**Europäisches Patentamt**

**European Patent Office**

**Office européen des brevets**

(19)

(11) Veröffentlichungsnummer: **0 121 841**
**A2**

# (12) EUROPÄISCHE PATENTANMELDUNG

(21) Anmeldenummer: **84103196.6**

(22) Anmeldetag: **22.03.84**

(51) Int. Cl.³: **H 03 K 13/00**

(30) Priorität: **07.04.83 DE 3312524**

(43) Veröffentlichungstag der Anmeldung: **17.10.84**
**Patentblatt 84/42**

(84) Benannte Vertragsstaaten: **DE FR GB IT SE**

(71) Anmelder: **Siemens Aktiengesellschaft, Berlin und München Wittelsbacherplatz 2, D-8000 München 2 (DE)**

(72) Erfinder: **Hafenrichter, Reinhard, Dipl.-Ing.,**
**Wilhelm-Busch-Strasse 19, D-8905 Mering (DE)**
Erfinder: **Jeschke, Alfred, Milbertshofener Strasse 15,**
**D-8000 München 40 (DE)**
Erfinder: **Lüder, Rainer, Dr.-Ing., Kohlstattstrasse 10,**
**D-8024 Oberhaching (DE)**

(54) **Verfahren zur Erhöhung der Zeitauflösung in digitalen Systemen.**

(57) Bei einem Verfahren zur Erhöhung der Zeitauflösung in digitalen Systemen besitzt ein in einem Taktraster T erzeugtes digitales Signal $S_1(t)$ die Pulsdauer $T_D = i \cdot T$ und nimmt die Signalamplituden O und A an. Wenn die Amplitude im Zeitintervall i, i + 1 eine von n-Stufen annimmt, so erhält man aus dem Signal $S_2(t)$ nach einer Bandbegrenzung das Signal $S_3(t)$, dessen Pulsdauer $T_D$ nun die Werte $T_D = (i + j/n) \cdot T$ annimmt. Das Signal $S_3(t)$ kann dann beispielsweise einer PDM-Endstufe zugeführt werden.

SIEMENS AKTIENGESELLSCHAFT
Berlin und München

Unser Zeichen
VPA 83 P 1 2 6 3 E

## Verfahren zur Erhöhung der Zeitauflösung in digitalen Systemen

Die Erfindung betrifft ein Verfahren zur Erhöhung der Zeitauflösung in digitalen Systemen, bei dem ein in einem Taktraster T erzeugtes digitales Signal der Pulsdauer $T_D = i.T$ (i ganzzahlig) die Signalamplituden O und A annimmt, insbesondere bei der Darstellung eines m-bit-Wortes E als PDM-Signal.

In digitalen Systemen können digitale Signale nur im Taktraster T erzeugt werden, wobei T die kleinste Taktperiode $T = 1/f$ ist. Dadurch ist beispielsweise eine Pulsdauer oder eine Zeitverzögerung stets ein ganzzahliges Vielfaches der Taktperiode T.

In vielen Anwendungsfällen wird jedoch eine feinere Zeitquantisierung benötigt, d.h. $\Delta T = T/n$ ($n \geqslant 2$, ganzzahlig). Ein Beispiel hierfür ist die bekannte Pulsdauermodulation (PDM). Wird nämlich in einem digitalen System der Abtastfrequenz $f_A$ ein m-bit Wort als PDM-Signal dargestellt, ist die Taktfrequenz $f = 1/T = 2^m \cdot f_A$ erforderlich. Bei Tonsignalen ist beispielsweise die Abtastfrequenz $f_A = 50$ kHz und m = 12 bit. Die erforderliche Taktfrequenz für ein PDM-Ausgangssignal ist somit f = 204,8 MHz. Ein derartiges digitales System ist, wenn überhaupt, nur mit unverhältnismäßig hohem Aufwand zu lösen.

Aufgabe der Erfindung ist es daher, ein Verfahren zur Erhöhung der Zeitauflösung in digitalen Systemen der eingangs genannten Art anzugeben, das ohne großen Aufwand durchführbar ist.

Sac 1 Gae / 05.04.1983

Diese Aufgabe wird erfindungsgemäß dadurch gelöst, daß das digitale Signal beim Übergang von 0 auf A und/oder von A auf 0 im Zeitintervall i, i+1, die Signalamplitude $j/n \cdot A$ (j, n ganzzahlig; $j < n$) annimmt.

Eine vorteilhafte Ausgestaltung des erfindungsgemäßen Verfahrens besteht darin, daß das m-bit-Wort E in $m_1$ höherwertige und $m_2$ niederwertige bit aufgeteilt wird, daß die $m_1$ höherwertigen bit in einen Abwärtszähler geladen werden, daß zum Zeitpunkt i = 1 in einem Register ein Ausgangswort erzeugt wird, das den $m_2$ niederwertigen bit entspricht, daß vom Zeitpunkt i = 2 an das Register das Wort 00... 00 enthält und ein weiteres Register den Wert MSB = 1 annimmt, daß bei Erreichen des Wertes 0 im Abwärtszähler MSB wieder 0 wird und daß die in den Registern enthaltenen Werte einem D/A-Wandler zugeleitet werden, an dessen Ausgang der dem Wort E entsprechende Analogwert abgegeben wird.

Eine weitere vorteilhafte Ausgestaltung besteht darin, daß das Wort E über ein Register und einen Multiplexer auf einen Addierer gegeben wird, daß der Addierer eine Konstante -C über eine Regelschleife so lange addiert, bis das Ergebnis $Z_i = E - i \cdot C$ negativ ist, daß in der Zweierkomplement-Arithemtik des Addierers ein Übertrag $c_i$ gebildet wird mit dem Wert 1, wenn $Z_i$ positiv, und dem Wert 0, wenn $Z_i$ negativ, daß, so lange $c_i = 1$ ist, über einen weiteren Multiplexer die Konstante C einem weiteren Register zugeführt wird, daß, wenn $c_i = 0$ wird, die $m_2$ niederwertigen bit des Ergebnisses $Z_{i-1}$ dem weiteren Register zugeführt werden, daß anschließend bis zum nächsten Impuls $f_A$ das Wort 00..0 dem weiteren Register zugeführt wird und daß die in dem weiteren Register enthaltenen Werte einem D/A-Wandler zugeleitet werden, an dessen Ausgang der dem Wort E entsprechende Analogwert abgegeben wird.

Bevorzugterweise entspricht die Konstante C dem Maximalwert MAX des D/A-Wandlers.

Die Vorteile des Gegenstandes der Erfindung werden anhand der folgenden Ausführungsbeispiele erläutert.

In der dazugehörenden Zeichnung zeigen
Fig. 1 die Pulsdauer eines digitalen Signals,
Fig. 2 ein Blockschaltbild eines Ausführungsbeispieles,
Fig. 3 das Impulsdiagramm des Ausführungsbeispieles nach
    Fig. 2,

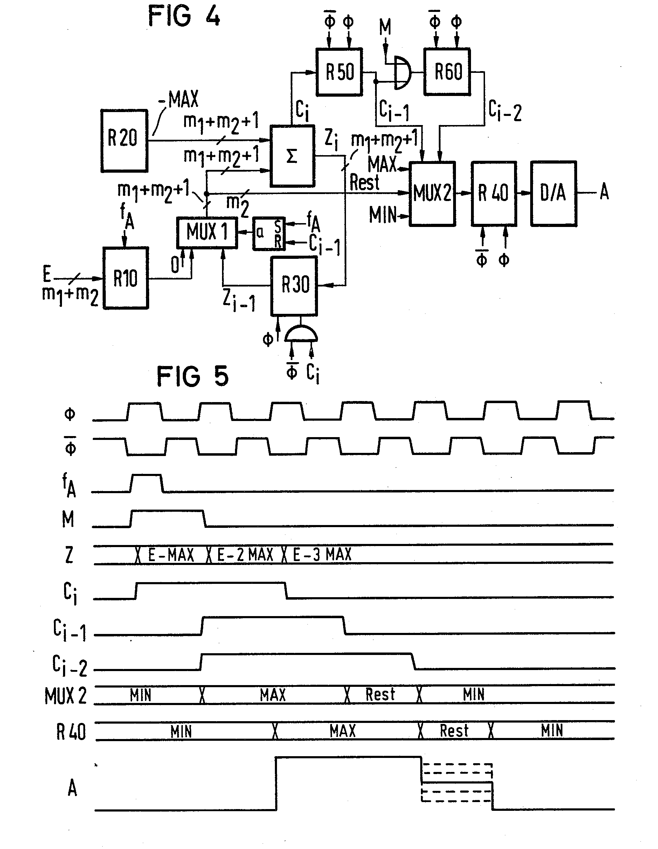

Fig. 4 ein Blockschaltbild eines weiteren Ausführungsbeispieles und
Fig. 5 das Impulsdiagramm des Ausführungsbeispieles gemäß
    Fig. 4.

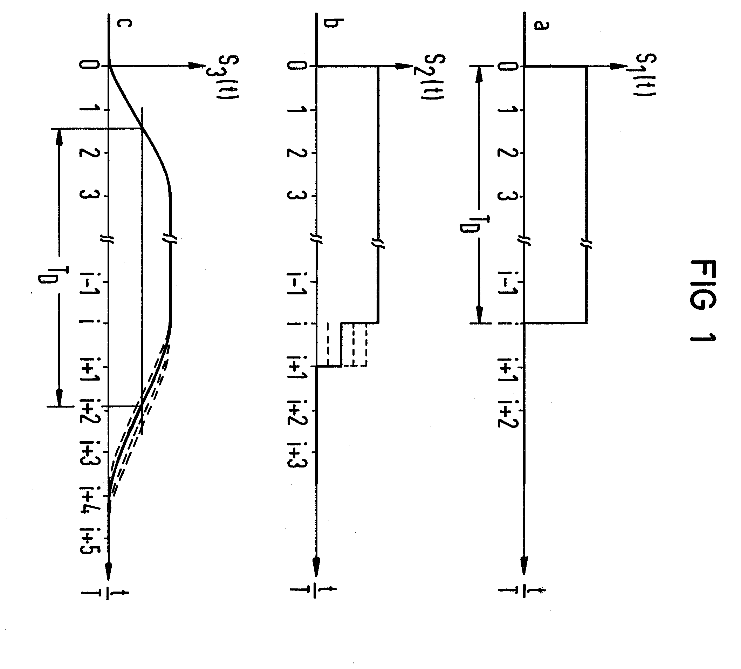

In der Fig. 1 ist mit a ein digitales Signal $S_1$ (t) dargestellt, dessen Pulsdauer $T_D$ nur im Taktraster T zu verändern ist. Es ist somit $T_D = i \cdot T$.

Die Kurve b der Figur 1 stellt ein digitales Signal dar, dessen Amplitude im Zeitintervall i, i + 1 eine von n-Stufen annehmen kann. Daduch erhält man aus dem Signal $S_2$ (t) nach einer Bandbegrenzung das mit der Kurve c dargestellte Signal $S_3$ (t), dessen Pulsdauer $T_D$ nun die Werte $T_D = (i + j/n) \cdot T$ annimmt. Der Tiefpaß zur Bandbegrenzung des Signals $S_2$ kann in vielen Fällen durch ein einfaches RC-Glied mit der Zeitkonstante $\tau > T$ ausgeführt werden. Das Signal $S_3$ (t) wird dann einer PDM-Endstufe zugeführt.

Das RC-Glied kann entfallen, wenn das Signal $S_2$ ohnehin einem Tiefpaß mit $f_g < f_A/2$ zugeführt wird.

Aus der Fig. 1 ist ersichtlich, daß mit dem erfindungsgemäßen Verfahren nicht nur die Pulsdauer $T_D$ mit höherer Zeitauflösung gebildet werden kann, sondern daß mit dem Gegenstand der Erfindung auch eine Zeitverzögerung ermöglicht wird.

Ferner ist es möglich, sowohl die positive als auch die negative Flanke eines Impulses durch das erfindungsgemäße Verfahren zu verschieben.

Wenn in einem digitalen System, das Tonsignale mit der Abtastfrequenz $f_A$ = 50 kHz verarbeitet und das die Takt- frequenz $f = 2^7 \cdot 50$ kHz = 6,4 MHz besitzt, ein 12 bit- Wort als PDM-Signal dargestellt werden soll, so genügt in diesem Fall ein 5 bit D/A-Wandler, um die Auflösung von 7 bit auf 7 + 5 = 12 bit zu erhöhen.

Der Gegenstand der Erfindung löst mit der Erhöhung der Zeitauflösung in digitalen Systemen gleichzeitig das Problem der Realisierung hochgenauer D/A-Wandler in integrierter Technik, da die Auflösung durch zwei unabhängige Prinzipien (Zeit- und Amplitudenquantisierung) erzielt wird.

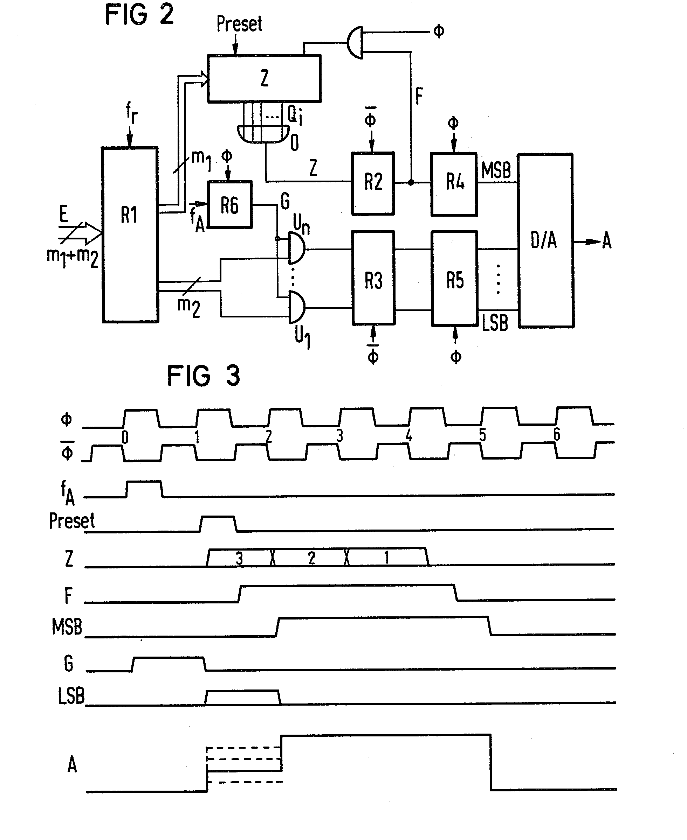

In der Fig. 2 ist das Blockschaltbild einer Ausführungsform dargestellt, bei der im Register R 1 mit der Ab- tastfrequenz $f_A$ ein $(m_1 + m_2)$ bit-Wort E eingespeist wird. Die $m_1$ höherwertigen bit werden in einen Abwärtszähler Z geladen.

Die $m_2$ niederwertigen bit werden über die UND-Glieder $U_1 ... U_n$ dem Register R 3 und von diesem dem Register R 5 zugeleitet. Die Ablaufsteuerung erzeugt nun zum Zeitpunkt $i = 1$ ein Ausgangswort im Register $R_5$, das den $m_2$ niederwertigen bit entspricht. Das Register R 6 dient dazu, den Eingangsimpuls $f_A$ auf eine Taktperiode zu verbreitern.

Der D/A-Wandler gibt dann den den $m_2$ niederwertigen bit entsprechenden Analogwert ab.

Vom Zeitpunkt $i = 2$ an enthält das Register R 5 das Wort 00...0 und das Register R 4 den Wert MSB = 1. Die Ausgänge des Abwärtszählers Z sind über das Oderglied O mit dem Register R 2 verbunden.

Erreicht der Abwärtszähler Z den Wert 0, so wird der Wert MSB im Register R 4 ebenfalls wiederum 0.

Das Integral über die Pulsdauer des Signals A entspricht exakt dem Wort E.

In der Fig. 3 ist das Impulsdiagramm des Ausführungsbeispieles gemäß Fig. 2 dargestellt, wobei die Bezeichnungen der einzelnen Kurven den in der Fig. 2 eingetragenen Impulsen entsprechen.

In der Fig. 4 ist das Blockschaltbild eines weiteren Ausführungsbeispieles dargestellt, in dem statt Zähler W eine Recheneinheit benutzt wird. Das Wort E wird über ein Register R 10 und einen Multiplexer MUX 1 auf einen Addierer $\Sigma$ gegeben, der das Wort -MAX addiert, das im Register R 20 enthalten ist. Ist E > MAX, so entsteht in der Zweierkomplement-Arithmetik ein Übertrag $c_i$. Solange nun $c_i = 1$ ist, wird vom jeweiligen Ergebnis $Z_i$

das Wort MAX subtrahiert und über einen weiteren Multiplexer MUX 2 das Wort MAX über das Register R 40 dem D/A-Wandler zugeführt.

Ist $c_i$ = O, so werden die $m_2$ niederwertigen bit des Ergebnisses $Z_{i-1}$ dem D/A-Wandler zugeführt und die Subtraktionsschleife (Register R 30) unterbrochen. Zum folgenden Taktzeitpunkt wird das Wort MIN (= OO...O) dem D/A-Wandler bis zum nächsten Impuls $f_A$ zugeführt.

Das Wort MAX entspricht vorzugsweise dem Maximalwert des D/A-Wandlers.

Es entsteht somit ein analoges Ausgangssignal A, dessen Integral wiederum dem Eingangswort proportional ist. Ist die Taktfrequenz $\phi = 2^m \cdot f_A$ und die Wortbreite des D/A-Wandlers k, so können die Zahlenwerte E = 0,1,2,..... $(2^{m+k} - 1)$ als PDM-Signal dargestellt werden.

In der Fig. 5 ist das Impulsdiagramm der in der Figur 4 dargestellten Schaltungsanordnung dargestellt, wobei die Bezeichnung der einzelnen Impulse in der Fig. 4 eingetragen ist.

4 Patentansprüche
5 Figuren

Patentansprüche

1. Verfahren zur Erhöhung der Zeitauflösung in digitalen Systemen, bei dem ein in einem Taktraster T erzeugtes digitales Signal der Pulsdauer $T_D = i \cdot T$ (i ganzzahlig) die Signalamplituden O und A annimmt, insbesondere bei der Darstellung eines m-bit-Wortes E als PDM-Signal, d a d u r c h   g e k e n n z e i c h n e t, daß das digitale Signal beim Übergang von O auf A und/oder von A auf O im Zeitintervall i, i + 1, die Signalamplitude $j/n \cdot A$ (j, n ganzzahlig; $j < n$) annimmt.

2. Verfahren nach Anspruch 1, d a d u r c h   g e -
k e n n z e i c h n e t, daß das m-bit-Wort E in $m_1$ höherwertige und $m_2$ niederwertige bit aufgeteilt wird, daß die $m_1$ höherwertigen bit in einen Abwärtszähler (Z) geladen werden, daß zum Zeitpunkt i = 1 in einem Register (R 5) ein Ausgangswort erzeugt wird, daß den $m_2$ niederwertigen bit entspricht, daß vom Zeitpunkt i = 2 an das Register (R 5) das Wort OO...O enthält und ein weiteres Register (R 4) den Wert MSB = 1 annimmt, daß bei Erreichen des Wertes O im Abwärtszähler (Z) MSB wieder O wird und daß die in den Registern (R 4, R 5) enthaltenen Werte einem D/A-Wandler zugeleitet werden, an dessen Ausgang der dem Wort E entsprechende Analogwert abgegeben wird.

3. Verfahren nach Anspruch 1, d a d u r c h   g e -
k e n n z e i c h n e t, daß das Wort E über ein Register (R 10) und einen Multiplexer (MUX 1) auf einen Addierer ( $\Sigma$ ) gegeben wird, daß der Addierer ( $\Sigma$ ) eine Konstante -C über eine Regelschleife (R 30) so lange addiert, bis das Ergebnis $Z_i = E - i \cdot C$ negativ ist,

daß in der Zweierkomplement-Arithmetik des Addierers ($\Sigma$) ein Übertrag $c_i$ gebildet wird mit dem Wert 1, wenn $Z_i$ positiv, und dem Wert 0, wenn $Z_i$ negativ, daß, so lange $c_i = 1$ ist, über einen weiteren Multiplexer (MUX 2) die Konstante C einem weiteren Register (R 40) zugeführt wird, daß wenn $c_i = 0$ wird, die $m_2$ niederwertigen bit des Ergebnisses $Z_{i-1}$ dem weiteren Register (R 40) zugeführt werden, daß anschließend bis zum nächsten Impuls $f_A$ das Wort 00...0 dem weiteren Register (R 40) zugeführt wird und daß die im weiteren Register (R 40) enthaltenen Werte einem D/A-Wandler zugeleitet werden, an dessen Ausgang der dem Wort E entsprechende Analogwert abgegeben wird.

4. Verfahren nach Anspruch 3, d a d u r c h   g e - k e n n z e i c h n e t,  daß die Konstante C dem Maximalwert MAX des D/A-Wandlers entspricht.

FIG 1

0121841

**FIG 2**

**FIG 3**

FIG 4

FIG 5